# EUROPÄISCHE PATENTSCHRIFT

(11) **EP 3 011 393 B1**
(45) Veröffentlichungstag und Bekanntmachung des Hinweises auf die Patenterteilung: **17.06.2020**
(21) Anmeldenummer: 14744751.0
(22) Anmeldetag: 20.06.2014
(51) Int. Cl.: G03F 7/20, G02B 26/12, G02B 27/00

(54) **SCANEINRICHTUNG**
SCANNING DEVICE
DISPOSITIF DE BALAYAGE

(30) Priorität: 21.06.2013 DE 102013106533
(43) Veröffentlichungstag der Anmeldung: 27.04.2016
(73) Patentinhaber: JENOPTIK Optical Systems GmbH, 07745 Jena (DE)
(72) Erfinder: KRÜGER, Ullrich, 07551 Milda (DE); DRESSLER, Thomas, 07749 Jena (DE); HEINEMANN, Stefan, 07745 Jena (DE)
(74) Vertreter: Schaller, Renate
(86) Internationale Anmeldenummer: PCT/DE2014/100204
(87) Internationale Veröffentlichungsnummer: WO 2014/202057

(56) Entgegenhaltungen:
- WO-A1-99/03012
- US-A1- 2012 002 261
- US-B1- 6 239 894

## Beschreibung

Die Erfindung betrifft eine Scaneinrichtung mit einer anamorphotischen katadioptischen Postscanoptik, wie sie gattungsgemäß aus der WO 99/03012 A1 bekannt ist. Weitere Scaneinrichtungen sind bekannt aus der US6239894 B1 und der US 2012/002261 A1.

Scaneinrichtungen werden z. B. in der Leiterplattendirektbelichtung eingesetzt, wo sie eine ebene Zieloberfläche mit einem Lichtbündel entlang einer Scanlinie in einer Scanrichtung abscannen, während die Zieloberfläche in einer zur Scanrichtung senkrecht verlaufenden Vorschubrichtung bewegt wird. Eine gattungsgemäße Scaneinrichtung, wie sie in der WO 99/03012 A1 offenbart ist, umfasst eine Lichtquelle, eine Scaneinheit, eine der Scaneinheit vorgeordnete Optik (Prescanoptik) zur Formung und Führung eines von der Lichtquelle kommenden Strahlenbündels auf die Scaneinheit und eine der Scaneinheit nachgeordnete Optik (Postscanoptik) zur Formung und Führung des durch die Scaneinheit abgelenkten Strahlenbündels auf eine Zieloberfläche.

Die Prescanoptik besteht gemäß einem Ausführungsbeispiel der vorgenannten WO 99/03012 A1 aus einem Zylinderspiegel und einem bizylindrischen, brechenden Element und bildet die Lichtquelle so in die Postscanoptik ab, dass die anamorphotischen Eigenschaften des Strahlenbündels, wie sie die Postscanoptik erfordert, bereitgestellt werden. Ein darüber hinaus vor der Scaneinrichtung angeordneter Umlenkspiegel und ein Einkoppelspiegel dienen lediglich der Strahlumlenkung bzw. Strahlumlenkung und Strahleinkopplung des Strahlenbündels in die Scaneinrichtung, gebildet durch einen Polygonspiegel unter einem Einkoppelwinkel in der Crossscanebene (dort unter einem sagittalen Einkoppelwinkel), den die Strahlachse des Strahlbündels mit den Flächennormalen der Polygonspiegelfassetten des Polygonspiegels einschließt.

Die Polygonspiegelfassetten reflektieren das Strahlenbündel in der Crossscanebene unter einem gleich großen Ausfallwinkel wie der Einfallswinkel in die Postscanoptik. Die Postscanoptik ist ein F-Theta-Objektiv, bei welchem verschiedene Arten von Verzeichnung auftreten können, die es gilt zu minimieren. Dazu gehören der Scanbogen und die Trapezverzeichnung.

Der Scanbogen ist eine Krümmung der Scanlinie gegenüber der Scanebene, die bei jedem F-Theta-Objektiv entsteht und sich verstärkt, je weiter entfernt der Bildort von der optischen Achse der Postscanoptik liegt.

Die Trapezverzeichnung ist von Projektoranordnungen bekannt, wenn das Bild in verschiedenen Höhen an eine Projektionsfläche projiziert werden soll. Am oberen Bildrand ist das Bild dann typischerweise breiter als am unteren Bildrand. Diese Art der Verzeichnung entsteht, wenn entweder das Objekt und/oder das Bild nicht senkrecht zur optischen Achse des Projektionsobjektivs angeordnet sind. Bei einem F-Theta-Objektiv ist der Einkoppelwinkel und gegebenenfalls eine zu ihm zentrierte Anordnung der Postscanoptik dafür bestimmend.

Für beide Ausführungen einer Scaneinrichtung gemäß der vorgenannten WO 99/03012 A1 wurde daher vorgeschlagen, die dem Polygonspiegel nachgeordnete Postscanoptik zentriert zum Polygonspiegel anzuordnen, das heißt, dass die optische Achse der Postscanoptik senkrecht auf der Drehachse des Polygonspiegels steht, womit das vom Polygonspiegel reflektierte Strahlenbündel unter einem Winkel zur optischen Achse der Postscanoptik, gleich dem Einfallswinkel, in die Postscanoptik eintritt und in einem Bildpunkt, welcher in einer die optische Achse einschließenden Ebene liegt, auf dem Zielobjekt abgebildet wird. Eine Anordnung der Postscanoptik zentriert zum Polygon ist die Anordnung mit der geringsten Verzeichnung. Gleichzeitig führt dies jedoch zu einem recht sperrigen Aufbau im Falle von größeren Einfallswinkeln des ankommenden Strahlenbündels.

Gemäß einer Ausführung umfasst die Postscanoptik in Strahlungsrichtung angeordnet einen sphärischen Meniskus und eine Planzylinderlinse, die gemeinsam ein Doublet bilden, und eine sphärische Zylinderlinse. Die vorgenannten drei optischen Elemente haben, vergleichbar mit dem Korrekturobjektiv einer erfindungsgemäßen Scaneinrichtung die Aufgabe, die durch die nachfolgende Spiegelanordnung zur Erzeugung eines telezentrischen Strahlengangs, nicht kompensierbaren Bildfehler zu beseitigen oder zu minimieren. Die nachfolgende Spiegelanordnung besteht aus einem ersten sphärischen Spiegel und einem zweiten sphärischen Spiegel und reflektiert das Strahlenbündel über eine sphärische Zylinderlinse in die Brennebene der Postscanoptik, die alle vorgenannten Elemente umfasst.

Eine Scaneinrichtung gemäß der vorgenannten WO 99/03012 A1 ist speziell für große Scanlängen (d. h. in der Regel eine lange Brennweite der Postscanoptik in Scanrichtung) nicht gut geeignet. Nachteilig ist insbesondere die große Baugröße der Spiegelanordnung durch den ersten sphärischen Spiegel, der ungefähr die doppelte Länge der zu erzeugenden Scanlinie hat.

Die Aufgabe der Erfindung besteht darin eine Scaneinrichtung für große Scanlängen zu finden, mit möglichst wenig optischen Bauteilen, die wiederum eine möglichst geringe Baugröße aufweisen, was zu Raum-, Gewichts- und Kostenersparnis führt. Darüber hinaus sollen die optischen Bauteile einfach herstellbar sein.

Diese Aufgabe wird für eine Scaneinrichtung zur Abbildung eines Strahlenbündels entlang einer Scanlinie, welche eine Lichtquelle, eine Scaneinheit mit einem Polygonspiegel, sowie eine dem Polygonspiegel vorgeordnete Prescanoptik und eine dem Polygonspiegel nachgeordnete Postscanoptik erfüllt. Die Prescanoptik ist dem Polygonspiegel so vorgeordnet, dass das Strahlbündel in einer Crossscanebene unter einem Einfallswinkel auf den Polygonspiegel auftrifft.

Es ist erfindungswesentlich, dass die optische Achse der Postscanoptik in Reflexionsrichtung des Polygonspiegels angeordnet ist. Die Postscanoptik umfasst in Richtung des Achsstrahls, nacheinander angeordnet, ein Korrekturobjektiv, mit wenigstens einer ersten und einer zweiten Korrekturlinse, sowie nur einen Zylinderspiegel und eine Zylinderlinse.

Der Zylinderspiegel ist um einen ersten Kippwinkel gegenüber der Flächennormalen des Polygonspiegels in der Crossscanebene verkippt, wobei der erste Kippwinkel β durch den Einfallswinkel α bestimmt ist. Eine der beiden Korrekturlinsen ist gegenüber der optischen Achse der Postscanoptik um einen zweiten Kippwinkel γ verkippt und einen Abstand a versetzt angeordnet.

Vorteilhaft liegt der erste Kippwinkel β im Bereich von 0,97α < β < 1,03α.

Um für die Postscanoptik die Telezentriebedingungen mit nur einer Zylinderlinse 4.3 zu erfüllen, ist der objektseitige Brennpunkt des Zylinderspiegels innerhalb des Polygonspiegels nahe der reflektierenden Polygonspiegelfassette angeordnet; und der Zylinderspiegel weist eine fokussierende Wirkung in der Scanebene, einer zur Crossscanrichtung senkrecht angeordneten Ebene auf.

Es ist von Vorteil, wenn das Strahlenbündel durch eine der beiden Korrekturlinsen schwach konvergierend oder divergierend geformt wird, wodurch die natürliche Bildfeldwölbung des Zylinderspiegels teilweise ausgeglichen und die Entfernung des Zylinderspiegels von der Scanlinie klein gehalten wird.

Nachfolgend soll die Scaneinrichtung anhand einer Zeichnung näher erläutert werden. Hierzu zeigen:

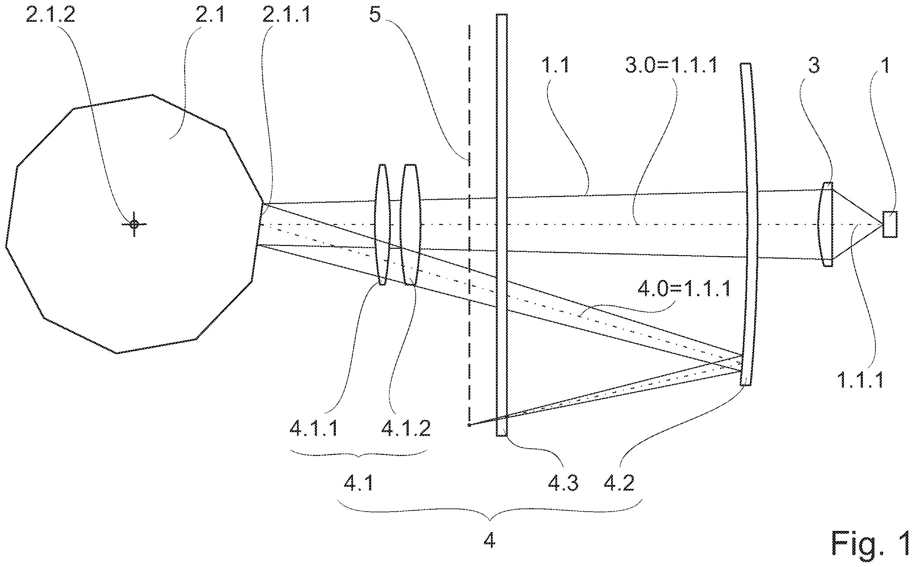

- Fig. 1: ein Optikschema einer Scaneinrichtung in senkrechter Draufsicht auf die Drehebene des Polygonspiegels und
- Fig. 2: das in Fig. 1 dargestellte Optikschema in Seitenansicht.

Gleich der im Stand der Technik beschriebenen Scaneinrichtung besteht eine erfindungsgemäße Scaneinrichtung aus einer Lichtquelle 1, welche ein Strahlenbündel 1.1 mit einem Achsstrahl 1.1.1 aussendet, einer Scaneinheit 2 mit einem Polygonspiegel 2.1, sowie einer dem Polygonspiegel 2.1 in Richtung des Achsstrahls 1.1.1 vorgeordnete Prescanoptik 3 und einer dem Polygonspiegel 2.1 in Richtung des Achsstrahls 1.1.1 nachgeordnete Postscanoptik 4.

Der Polygonspiegel 2.1 ist um eine Drehachse 2.1.2 rotierbar und weist eine Vielzahl von Polygonspiegelfassetten 2.1.1 auf, deren Flächennormalen senkrecht zur Drehachse 2.1.2 eine Drehebene des Polygonspiegels 2.1.3 aufspannen.

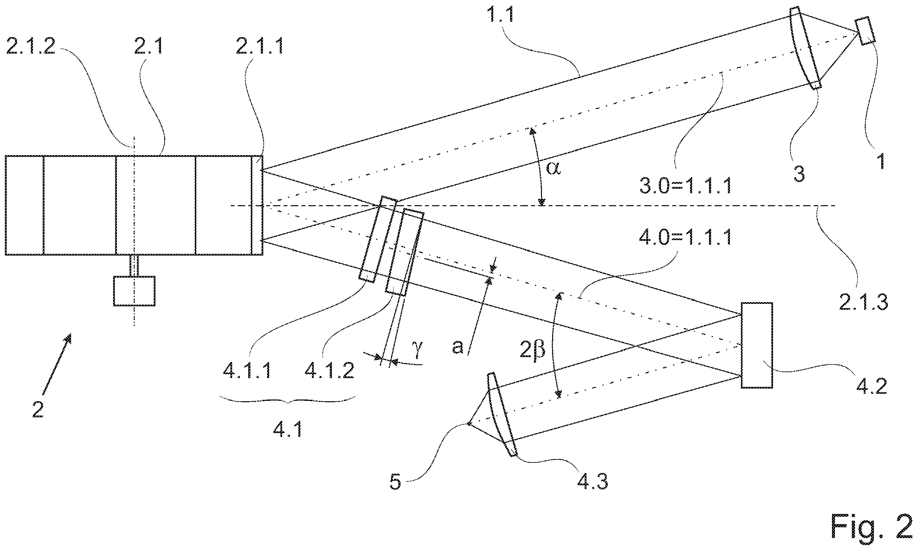

Als Crossscanebene wird eine Ebene verstanden, welche die optische Achse der Prescanoptik 3.0 und die Drehachse des Polygonspiegels 2.1.2 umfasst. Sie liegt damit bei dem in Fig. 2 gezeigten Optikschema oberhalb der Drehebene 2.1.3 in der Zeichenebene und unterhalb der Drehebene 2.1.3 unterhalb der Zeichenebene.

Die unausgelenkte Polygonspiegelstellung ist die Stellung des Polygonspiegels 2.1, in welcher der von der Prescanoptik 3 in die Postscanoptik 4 reflektierte Achsstrahl weiterhin in der Crossscanebene liegt.

Die Scanebene, deren Lage sich mit der Umlenkung des Strahlenbündels 1.1 am rotierenden Polygonspiegel 2.1 und am Zylinderspiegel 4.2 jeweils ändert, steht jeweils senkrecht auf der Crossscanebene und beinhaltet den Achsstrahl in unausgelenkter Polygonspiegelstellung.

Die Abbildungseigenschaften der Postscanoptik 4 sind in der Crossscanebene und der hierzu senkrechten Ebene sehr unterschiedlich, womit extrem unterschiedliche Geometrien der Strahlenbündel 1.1 entstehen.

In der Crossscanebene trifft das Strahlenbündel 1.1 unter einem Einfallswinkel α auf eine Polygonspiegelfassette 2.1.1 des Polygonspiegels 2.1, wird unter einem Reflexionswinkel gleicher Größe in die optische Achse der Postscanoptik 4.0 und damit des nachgeordneten Korrekturobjektivs 4.1 reflektiert und über den Zylinderspiegel 4.2, der in dieser Richtung keine Brechkraft aufweist, mit der Zylinderlinse 4.3 in die bildseitige Brennebene der Postscanoptik 4 in einem Fokuspunkt abgebildet. Die Scanlinie 5 beinhaltet diesen Fokuspunkt mit unausgelenkter Polygonstellung und ist senkrecht zur Crossscanebene ausgerichtet.

Indem die Postscanoptik 4 so zum Polygonspiegel 2.1 angeordnet wird, dass das Strahlenbündel 1.1 in die optische Achse der Postscanoptik 4.0 eingekoppelt wird, entstehen, wie in der vorgenannten WO 99/03012 A1 als nachteilig beschrieben, die beiden Verzeichnungsarten Trapezverzeichnung und Scanbogen.

Diese beiden Verzeichnungsarten werden, wie noch genauer erklärt wird, erfindungsgemäß durch eine spezielle Anordnung des Zylinderspiegels 4.2 sowie einer der Korrekturlinsen 4.1.1, 4.1.2 zur optischen Achse der Postscanoptik 4.0 sehr klein gehalten.

Senkrecht zur Crossscanebene wird das von der Lichtquelle 1 kommende Strahlenbündel 1.1 durch die Prescanoptik 3 im wesentlichen so aufgeweitet und in ein schwach konvergierendes Strahlenbündel 1.1 geformt und geführt, dass beim Auftreffen auf den Polygonspiegel 2.1 eine Polygonspiegelfassette 2.1.1 jeweils mittig beleuchtet wird. Es wird vom Polygonspiegel 2.1 windschief in die Postscanoptik 4 reflektiert und durch das Korrekturobjektiv 4.1 und den Zylinderspiegel 4.2 in die bildseitige Brennebene der Postscanoptik 4 fokussiert.

Die Postscanoptik 4 umfasst in Richtung des Achsstrahls 1.1.1 nacheinander angeordnet ein Korrekturobjektiv 4.1, mit wenigstens einer ersten und einer zweiten Korrekturlinse 4.1.1, 4.1.2, einen Zylinderspiegel 4.2 und eine Zylinderlinse 4.3. Verglichen mit einer Postscanoptik der vorgenannten WO 99/03012 A1 ist eine erfindungsgemäße Postscanoptik 4 so konzipiert und gerechnet, dass sie mit nur einem Zylinderspiegel 4.2 auskommt und die Korrekturlinsen 4.1.1, 4.1.2 und speziell der Zylinderspiegel 4.2 vergleichsweise kleiner und einfacher herstellbar sind. Besonders für große Scanlängen, z. B. solche größer 300 mm und mit einer damit verbundenen großen Brennweite einer Postscanoptik, ist es grundsätzlich von Vorteil, wenn vorhandene Korrekturlinsen in Streifenform ausgeführt werden.

Indem die Postscanoptik 4 erfindungsgemäß zentriert zu dem vom Polygonspiegel 2.1 reflektierten Strahlenbündel 1.1 und damit koaxial zur Einkoppelrichtung des Strahlenbündels 1.1 in die Postscanoptik 4 angeordnet wird, entstehen vergleichsweise geringere Streifenhöhen für die Korrekturlinsen 4.1.1, 4.1.2, wenn man davon ausgeht, dass streifenförmige Korrekturlinsen zur Erreichung einer hohen Qualität grundsätzlich so hergestellt werden, dass sie den Bereich um ihre optische Achse körperlich mit umfassen.

Der durch diese Anordnung entstehende Scanbogen und die bildseitige Telezentrie in der Crossscanebene wird durch eine auf den Einfallswinkel α abgestimmte Kippung des Zylinderspiegels 4.2 in der Crossscanebene um den ersten Kippwinkel β minimiert. Die Einstellung eines Kippwinkels β im Bereich von 0,97α < β < 1,03α minimiert den Scanbogen und die Abweichung von der Telezentrie ausreichend.

Die verbleibende Trapezverzeichnung wird durch den Versatz um einen Abstand a und Kippung um einen zweiten Kippwinkel γ der ersten oder zweiten Korrekturlinse 4.1.1, 4.1.2 in der Crossscanebene zur optischen Achse der Postscanoptik 4.0 vermindert. Am besten eignet sich hierfür diejenige der beiden Korrekturlinsen 4.1.1, 4.1.2 mit der größeren Brechkraft. Der Versatz um den Abstand a und die Kippung um den zweiten Kippwinkel γ werden so aufeinander abgestimmt, dass die Trapezverzeichnung ausreichend klein wird und der Einfluss auf alle anderen Parameter der Abbildung z. B. die Abbildungsgüte nur minimal ist. Die Prescanoptik 3 kann damit, in Crossscanebene betrachtet, bei einem nur kleinen Einkoppelwinkel α oberhalb der Postscanoptik 4 angeordnet werden, sodass die Einkopplung des Strahlenbündels 1.1 über das Korrekturobjektiv 4.1 hinweg durch die geringere Streifenhöhe der ersten und zweiten Korrekturlinse 4.1.1, 4.1.2 ebenfalls erleichtert wird. Dadurch kann auf ein Umlenkelement in der Nähe des Polygonspiegels 2.1 verzichtet werden, was zu einer deutlichen Verbesserung der Stabilität der Anordnung führt.

Die Prescanoptik 3 hat die Aufgabe die Lichtquelle 1 so in die Postscanoptik 4 abzubilden, dass die anamorphotischen Eigenschaften des Strahlenbündels 1.1, wie sie die Postscanoptik 4 erfordert, bereitgestellt sind. Sie weist in der Crossscanebene entsprechend dem Stand der Technik einen Fokus möglichst nahe am Polygonspiegel 2.1 auf, womit ein auftretender Wobbelfehler minimal gehalten wird. In der dazu senkrechten Ebene wird ein schwach konvergentes Strahlenbündel 1.1, angepasst an die natürliche Bildfeldwölbung der Postscanoptik 4, bereitgestellt. Dabei wird die Lichtquelle 1 so abgebildet, dass auf der Scanlinie 5 die für die Aufgabe geforderte bildseitige Apertur entsteht.

Die primäre Funktion der Postscanoptik 4 wird durch den in der Scanebene wirkenden Zylinderspiegel 4.2 und die in der Crossscanebene wirkende Zylinderlinse 4.3 realisiert. Um die Telezentriebedingungen zu erfüllen, ist der objektseitige Brennpunkt des Zylinderspiegels 4.2 innerhalb des Polygonspiegels 2.1, nahe der reflektierenden Polygonspiegelfassette 2.1.1, angeordnet. Gleichzeitig hat der Zylinderspiegel 4.2 in der Scanebene eine fokussierende Wirkung, wodurch ein kollimiertes Strahlenbündel 1.1 im bildseitigen Brennpunkt der Postscanoptik 4 fokussiert abgebildet werden würde. Durch Formung eines (schwach) konvergenten oder divergenten Strahlenbündels 1.1 kann die natürliche Bildfeldwölbung des Zylinderspiegels 4.2 teilweise ausgeglichen werden.

Dies ist allerdings nur für geringe bildseitige numerische Aperturen ausreichend. Für eine Scaneinrichtung mit einer Scanlänge von ca. 600 mm und einem Polygonspiegel 2.1 mit 15 Polygonspiegelfassetten 2.1.1 wird ab einer bildseitigen numerischen Apertur von 0,012 auch in diesem Fall die Bildfeldwölbung zu groß, was durch diejenige der beiden Korrekturlinsen 4.1.1, 4.1.2 kompensiert wird, welche eine deutlich geringere Brechkraft als der Zylinderspiegel 4.2 aufweist.

Für die gleiche Scaneinrichtung mit einer bildseitigen numerischen Apertur > 0,015 wächst die Koma zum Scanrand hin signifikant an, was durch die andere der beiden Korrekturlinsen 4.1.1, 4.1.2, eine nahezu konzentrische Meniskuslinse, kompensiert wird.

Beide Korrekturlinsen 4.1.1, 4.1.2 sind nahe dem Polygonspiegel 2.1 angeordnet, was zu einer geringen Baugröße der Scaneinrichtung beiträgt.

Für Anwendungen mit einer breitbandigen Lichtquelle 1.1 muss gegebenenfalls die spektrale Wirkung des Korrekturobjektivs 4.1 durch eine geeignete Materialwahl für die beiden Korrekturlinsen 4.1.1, 4.1.2 gering gehalten werden oder eine zusätzliche dritte Korrekturlinse 4.1.3 zur Achromatisierung eingesetzt werden.

Die Abbildung in der Crossscanebene wird durch das Korrekturobjektiv 4.1 und den Zylinderspiegel 4.2 nur wenig beeinflusst. Die Fokussierung des in der Nähe des Polygonsspiegels 2.1 durch die Prescanoptik 3 erzeugten Bildes der Lichtquelle 1 erfolgt mittels der sphärischen Zylinderlinse 4.3. Diese Zylinderlinse 4.3 wird bei hinreichend großer bildseitiger numerischer Apertur Öffnungs- und Farblängsfehler erzeugen. Beides ist über die Länge der Scanlinie 5 nahezu konstant und kann daher mit der Prescanoptik 3 aufgehoben werden.

### Bezugszeichenliste

- 1: Lichtquelle
- 1.1: Strahlenbündel
- 1.1.1: Achsstrahl
- 2: Scaneinheit
- 2.1: Polygonspiegel
- 2.1.1: Polygonspiegelfassette
- 2.1.2: Drehachse des Polygonspiegels
- 2.1.3: Drehebene des Polygonspiegels
- 3: Prescanoptik
- 3.0: optische Achse der Prescanoptik
- 4: Postscanoptik
- 4.0: optische Achse der Postscanoptik
- 4.1: Korrekturobjektiv
- 4.1.1: erste Korrekturlinse
- 4.1.2: zweite Korrekturlinse
- 4.2: Zylinderspiegel
- 4.3: Zylinderlinse
- 5: Scanlinie

- α: Einfallswinkel
- β: erster Kippwinkel
- γ: zweiter Kippwinkel
- a: Abstand

## Patentansprüche

1. Scaneinrichtung zur Abbildung eines Strahlenbündels (1.1) entlang einer Scanlinie (5), enthaltend eine Lichtquelle (1), welche das Strahlenbündel (1.1) mit einem Achsstrahl (1.1.1) aussendet, eine Scaneinheit (2) mit einem Polygonspiegel (2.1), sowie eine dem Polygonspiegel (2.1) in Richtung des Achsstrahls (1.1.1) vorgeordnete Prescanoptik (3) und eine dem Polygonspiegel (2.1) in Richtung des Achsstrahls (1.1.1) nachgeordnete Postscanoptik (4), mit einer optischen Achse (4.0), wobei die Prescanoptik (3) so dem Polygonspiegel (2.1) vorgeordnet ist, dass das Strahlenbündel (1.1) in einer Crossscanebene unter einem Einfallswinkel (α) auf den Polygonspiegel (2.1) auftrifft, **dadurch gekennzeichnet, dass**
die optische Achse (4.0) der Postscanoptik (4) in Reflexionsrichtung des Polygonspiegels (2.1) angeordnet ist,
die Postscanoptik (4) in Richtung des Achsstrahls (1.1.1) nacheinander angeordnet ein Korrekturobjektiv (4.1), mit wenigstens einer ersten Korrekturlinse (4.1.1) und einer zweiten Korrekturlinse (4.1.2), nur einen Zylinderspiegel (4.2) und eine Zylinderlinse (4.3) umfasst,
der Zylinderspiegel (4.2) um einen ersten Kippwinkel (β) gegenüber der Flächennormalen des Polygonspiegels (2.1) in der Crossscanebene verkippt ist, der durch den Einfallswinkel (α) bestimmt ist, und
eine der beiden Korrekturlinsen (4.1.1, 4.1.2) gegenüber der optischen Achse (4.0) der Postscanoptik (4) um einen zweiten Kippwinkel (γ) verkippt und einen Abstand (a) versetzt angeordnet ist.

2. Scaneinrichtung nach Anspruch 1, **dadurch gekennzeichnet, dass** der erste Kippwinkel (β) im Bereich von 0,97α < β < 1,03α liegt.

3. Scaneinrichtung nach einem der vorherigen Ansprüche, **dadurch gekennzeichnet, dass**
der objektseitige Brennpunkt des Zylinderspiegels (4.2) innerhalb des Polygonspiegels (2.1) nahe der reflektierenden Polygonspiegelfassette (2.1.1) angeordnet ist und der Zylinderspiegel (4.2) eine fokussierende Wirkung in der Scanebene, einer zur Crossscanrichtung senkrecht angeordneten Ebene, aufweist, sodass die Telezentriebedingungen mit nur einer Zylinderlinse (4.3) erfüllt werden.

4. Scaneinrichtung nach einem der vorherigen Ansprüche, **dadurch gekennzeichnet, dass**
das Strahlenbündel (1.1) durch eine der beiden Korrekturlinsen (4.1.1, 4.1.2) schwach konvergierend oder divergierend geformt wird, womit die natürliche Bildfeldwölbung des Zylinderspiegels (4.2) teilweise ausgeglichen und die Entfernung des Zylinderspiegels (4.2) von der Scanlinie (5) klein gehalten wird.

## Claims

1. A scanning device for imaging a beam (1.1) along a scan line (5), comprising a light source (1) which emits the beam (1.1) with an axial ray (1.1.1), a scanning unit (2) with a polygon mirror (2.1), as well as prescan optics (3) arranged upstream of the polygon mirror (2.1) in the direction of the axial ray (1.1.1) and prescan optics (4) arranged downstream of the polygon mirror (2.1) in the direction of the axial ray (1.1.1), with an optical axis (4.0), the prescan optics (3) being arranged upstream of the polygon mirror (2.1) in such a way that the beam (1.1) impinges on the polygon mirror (2.1) in a cross scan plane at an angle of incidence (a), **characterized in that** the optical axis (4.0) of the postscan optics (4) is arranged in the reflection direction of the polygon mirror (2.1),
the postscan optics (4) comprise, arranged successively in the direction of the axial ray (1.1.1), a corrective objective (4.1) with at least a first corrective lens (4.1.1) and a second corrective lens (4.1.2), only one cylindrical mirror (4.2) and one cylindrical lens (4.3),
the cylindrical mirror (4.2) is tilted at a first tilt angle (β) with respect to the surface normal of the polygon mirror (2.1) in the cross scan plane, said tilt angle (β) being determined by the angle of incidence (a), and
one of the two corrective lenses (4.1.1, 4.1.2) is tilted relative to the optical axis (4.0) of the postscan optics (4) at a second tilt angle (γ) and is offset with respect to the optical axis (4.0) by a distance (a).

2. The scanning device according to claim 1, **characterized in that** the first tilt angle (β) is in the range of 0.97a < β < 1.03α.

3. The scanning device according to any one of the preceding claims, **characterized in that**
the object-side focal point of the cylindrical mirror (4.2) is arranged within the polygon mirror (2.1) near the reflecting polygon mirror facet (2.1.1) and the cylindrical mirror (4.2) has a focusing effect in the scan plane, which is a plane perpendicular to the cross scan direction, so that the telecentricity conditions are satisfied using only one cylindrical lens (4.3).

4. The scanning device according to any one of the preceding claims, **characterized in that**
the beam (1.1) is formed by one of the two corrective lenses (4.1.1, 4.1.2) in a slightly converging or diverging manner, so that the natural image field curvature of the cylindrical mirror (4.2) is partially compensated and the distance between the cylindrical mirror (4.2) and the scan line (5) is kept short.

## Revendications

1. Dispositif de balayage pour la reproduction d'un faisceau (1.1) selon une ligne de balayage (5), comprenant une source de lumière (1) qui émet le faisceau (1.1) avec un rayon axial (1.1.1), une unité de balayage (2) avec un miroir polygonal (2.1), ainsi qu'une optique de pré-balayage (3) disposée en amont du miroir polygonal (2.1) dans la direction du rayon axial (1.1.1) et une optique de post-balayage (4) disposée en aval du miroir polygonal (2.1) dans la direction du rayon axial (1.1.1), avec un axe optique (4.0), l'optique de pré-balayage (3) étant disposée en amont du miroir polygonal (2.1) de telle sorte que le faisceau (1.1) est incident sur le miroir polygonal (2.1) dans un plan de balayage transversal sous un angle d'incidence (a), **caractérisé en ce que**
l'axe optique (4.0) de l'optique de post-balayage (4) est disposé dans la direction de réflexion du miroir polygonal (2.1),
l'optique de post-balayage (4) comprend, disposés en succession dans la direction du rayon axial (1.1.1), un objectif de correction (4.1) avec au moins une première lentille de correction (4.1.1) et une deuxième lentille de correction (4.1.2), un seul miroir cylindrique (4.2) et une seule lentille cylindrique (4.3),
le miroir cylindrique (4.2) est incliné d'un premier angle d'inclinaison (β) par rapport à la normale à la surface du miroir polygonal (2.1) dans le plan de balayage transversal, qui est déterminé par l'angle d'incidence (a), et
une des deux lentilles de correction (4.1.1, 4.1.2) est inclinée d'un deuxième angle d'inclinaison (γ) par rapport à l'axe optique (4.0) de l'optique de post-balayage (4) et est décalée d'une distance (a) par rapport à l'axe optique (4.0).

2. Dispositif de balayage selon la revendication 1, **caractérisé en ce que** le premier angle d'inclinaison (β) se situe dans la plage de 0,97α < β < 1,03α.

3. Dispositif de balayage selon l'une quelconque des revendications précédentes, **caractérisé en ce que**
le point focal côté objet du miroir cylindrique (4.2) est disposé à l'intérieur du miroir polygonal (2.1) près de la facette réfléchissante (2.1.1) du miroir polygonal et le miroir cylindrique (4.2) a un effet de focalisation dans le plan de balayage, qui est un plan perpendiculaire à la direction de balayage transversal, de sorte que les conditions télécentriques sont remplies avec une seule lentille cylindrique (4.3).

4. Dispositif de balayage selon l'une quelconque des revendications précédentes, **caractérisé en ce que**
le faisceau (1.1) est formé par l'une des deux lentilles de correction (4.1.1, 4.1.2) de manière légèrement convergente ou divergente, la courbure naturelle du champ d'image du miroir cylindrique (4.2) étant partiellement compensée et la distance du miroir cylindrique (4.2) par rapport à la ligne de balayage (5) étant maintenue faible.
